# EUROPEAN PATENT APPLICATION

(11) **EP 2 908 350 A1**
(43) Date of publication of application: **19.08.2015**
(21) Application number: 12886387.5
(22) Date of filing: 11.10.2012
(51) Int. Cl.: H01L 31/042

(54) **SOLAR CELL MODULE**

(71) Applicant: Panasonic Intellectual Property Management Co., Ltd., Osaka-shi, Osaka 540-6207 (JP)
(72) Inventor: SAITA, Atsushi, Osaka-shi, Osaka 540-6207 (JP); IMADA, Naoto, Osaka-shi, Osaka 540-6207 (JP)
(74) Representative: Klunker . Schmitt-Nilson . Hirsch
(86) International application number: PCT/JP2012/076343
(87) International publication number: WO 2014/057561

(57) **Abstract**

A solar cell module (10) includes: solar cells (11); a colored layer (20) serving as a first reflective layer disposed at the rear sides of the solar cells (11) and including a coloring agent with a higher refractive index than the main material of the colored layer; an intermediate transparent layer (22) disposed at the rear side of the colored layer (20) and having a higher transmission factor than the colored layer (20) ; and a protective member (17) at the rear side of the module, serving as a second reflective layer disposed at the rear side of the intermediate transparent layer (22), including a whitened portion having a higher refractive index than the main material of the protective member, and having a higher refractive index for the entire layer than the intermediate transparent layer (22). A sealing member at the rear side of the module includes the colored layer (20) and the intermediate transparent layer (22).

## Description

### Technical Field

The present invention relates to a solar cell module in which a sealing member at the rear side of a solar cell reflects light from the light-receiving face side.

### Background Art

A solar cell module is configured so that a solar cell element is sealed by a sealing member to thereby reduce the impact from the exterior and to prevent the ingression of water or contaminated substances.

A sealing member used in a solar cell element has been required to provide transparency, heat resistance, adhesiveness to a protective member, and deterioration resistance against sunlight, for example. Thus, various blend formulations have been examined to satisfy these requiremets. In recent years, it has been shown that in order to increase the power generation efficiency of a solar cell, a white sealing member including white colorant is used as a sealing member at the rear side of a solar cell element (Patent Publication 1).

### Prior Art Publication

### Patent Publication

Patent Publication 1: Japanese Patent Laid-Open Publication No. 2006-36874

### Summary of the Invention

### Problem to be Solved by the Invention

In a solar cell module, the reflection of light from the light-receiving face side is performed in a more efficient manner.

### Means for Solving the Problem

A solar cell module includes: solar cells; a colored layer serving as a first reflective layer disposed at the rear sides of the solar cells and including a coloring agent with a higher refractive index than the main material of the colored layer; an intermediate transparent layer disposed at the rear side of the colored layer and having a higher transmission factor than the colored layer; and a protective member at the rear side of the module, serving as a second reflective layer disposed at the rear side of the intermediate transparent layer, including a whitened portion having a higher refractive index than the main material of the protective member, and having a higher refractive index for the entire layer than the intermediate transparent layer.

### Effect of the Invention

Light transmitted through the first reflective layer is reflected by the second reflective layer. Thus, light can be reflected from the light-receiving face side in a more efficient manner.

### Brief Description of the Drawings

FIG. 1 illustrates the configuration of a solar cell module in an embodiment of the present invention.
FIG. 2 is an expanded view of FIG. 1.
FIG. 3 illustrates an example in which a transparent layer is formed as a compound transparent layer in the solar cell module of an embodiment of the present invention.
FIG. 4 illustrates the light reflection from a light-receiving face side in the configuration of FIG. 2.

### Embodiment for Carrying Out the Invention

The following section will describe an embodiment of the present invention in detail. Materials, thicknesses, and sizes for examples described below are exemplary for illustration and can be appropriately changed depending on the specification of a solar cell module. In the following description, the same or corresponding elements are denoted with the same reference numerals in all drawings and will not be described further.

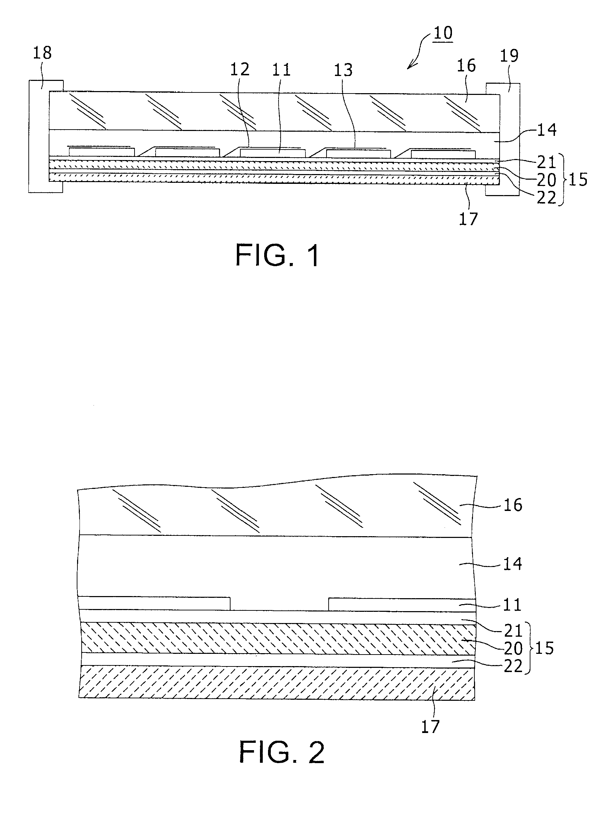

FIG. 1 is a cross-sectional view illustrating a solar cell module 10. A solar cell 11 constituting the solar cell module 10 has a light-receiving face that functions as a main face and that is a face to which light from the exterior of the solar cell 11 mainly enters, and a back face that is a face at an opposite side of the light-receiving face. In FIG. 1, the upper side of the paper is shown as a light-receiving face side and the lower side is shown as a rear side.

The solar cell module 10 is configured so that a plurality of solar cells 11 are mutually series-connected using a plurality of wiring members 12 and 13 and the resultant structure is sandwiched between a sealing member 14 at the light-receiving face side and a sealing member 15 at the rear side. The outer side has a protective member 16 at the light-receiving face side and a protective member 17 at the rear side, and the ends are fixed by frames 18 and 19.

The solar cell 11 includes a photoelectric conversion component that receives light such as sunlight to thereby generate holes and electron photogenerated carriers. The photoelectric conversion component has, for example, a substrate of semiconductor material such as crystalline silicon (c-Si), gallium arsenide (GaAs), or indium phosphide (InP). The photoelectric conversion component has a structure that is, in a broad sense, a pn junction. For example, a hetero junction of n-type monocrystal silicon substrate and amorphous silicon can be used. In this case, the substrate at the light-receiving face side has thereon a multilayer structure of an i-type amorphous silicon layer, a p-type amorphous silicon layer doped with boron (B) for example, and a transparent conducting layer (TCO) composed of translucent conducting oxide of indium oxide (In₂O₃). The rear side of the substrate has thereon a structure of an i-type amorphous silicon layer, an n-type amorphous silicon layer doped with phosphorus (P) for example, and a transparent conducting layer.

The photoelectric conversion component may have a structure other than this so long as the photoelectric conversion component has a function to electrically convert light such as sunlight. For example, the photoelectric conversion component also may have a structure including a p-type polycrystal silicon substrate, an n-type diffusion layer formed at the light-receiving face side, and an aluminium metal film formed at the rear side.

The wiring members 12 and 13 are a conductive member that is formed on the surface of a transparent conducting layer on the photoelectric conversion component using conductive paste, for example, and that is connected to a connection electrode via adhesive agent. The wiring members 12 and 13 are formed by a thin plate composed of metal conductive material such as copper. A thin plate may also be substituted with a twisted wire. Conductive material may be, in addition to copper, silver, aluminium, nickel, tin, gold, or an alloy thereof.

Adhesive agent can be acrylic-based adhesive agent, elastic polyurethane adhesive agent, or epoxy-based thermosetting resin adhesive agent. Adhesive agent includes conductive particles. Conductive particles can be made of nickel, silver, gold-coated nickel, or tin-plated copper, for example. Adhesive agent may also be insulating resin adhesive agent. In this case, one or both of the mutually-opposed faces of the wiring members 12 and 13, or the connection electrode, are formed to have a concavo-convex shape so that resin can be appropriately removed from between the wiring members 12 and 13 and the connection electrode to establish electrical connection.

The sealing member 14 at the light-receiving face side and the sealing member 15 at the rear side are members that function as impact buffer material to the solar cell 11, that function to prevent the ingression of contaminated substances, foreign material, or water, for example, and that are formed to have a layer-like shape. The sealing members 14 and 15 are made of material selected in consideration of heat resistance, adhesiveness, flexibility, moldability, and durability for example. The sealing member 14 at the light-receiving face side is formed, in order to receive light from the exterior, of a transparent sealing member that has the highest transparency so that incident light is transmitted without being absorbed or reflected. For example, polyethylene-base olefin resin or ethylene vinyl acetate (EVA) for example is used. In addition to polyethylene-based olefin resin or EVA, EEA, PVB, silicon-based resin, urethane-based resin, acrylic-based resin, or epoxy-based resin for example also can be used. Non EVA-based resin is preferably cross linking-type resin.

In order to reflect the light from the light-receiving face side of the solar cell 11 and introduce the light to the rear side of the solar cell 11, the sealing member 15 has a three layer-structure composed of the colored layer 20, the transparent upper face layer 21 provided at the light-receiving face side of the colored layer 20, and the intermediate transparent layer 22 provided between the colored layer 20 and the protective member 17.

The protective member 16 at the light-receiving face side is a transparent plate or film that can receive light from the exterior. The protective member 16 at the light-receiving face side can be a translucent member such as a glass plate, a resin plate, or a resin film.

The protective member 17 at the rear side is a resin film that is colored to reflect the light from the light-receiving face side of the solar cell 11 and introduce the light to the rear side of the solar cell 11.

FIG. 2 is an expanded view illustrating a space part sandwiched between neighboring solar cells 11 in order to explain the structure and the thickness relation of the rear side. A region of a part of the space sandwiched between the neighboring solar cells 11 has wiring member 13 for connecting the neighboring solar cells 11. However, for the purpose of explaining the structure of the sealing member 15, FIG. 2 illustrates a region not having the wiring member 13.

A transparent upper face layer 21 is a transparent film not including coloring agent that is an uppermost layer constituting the sealing member 15 and that is provided between the back face of the solar cell 11 and a colored layer 20. The transparent upper face layer 21 prevents the colored layer 20 from moving to the sealing member 14 at the light-receiving face side. The transparent upper face layer 21 can be formed by the same polyethylene-based olefin resin or EVA as in the sealing member 15. The transparent upper face layer 21 has an exemplary thickness of about 100 to 150µm. The transparent upper face layer 21 also is effective to improve the adhesiveness with the solar cell 11. Since the colored layer 20 includes coloring agent such as inorganic colorant, the colored layer 20 has a lower adhesive strength compared with the transparent upper face layer 21.

The colored layer 20 constituting the sealing member 15 is a film obtained by mixing transparent main material with coloring agent. The main material can be polyethylene-based olefin resin or EVA. The main material can be colored white, for example, by using inorganic colorant (e.g., oxidized titanium, calcium carbonate, or zinc oxid) as coloring agent. The main material that is transparent resin has a refractive index of about 1.49 to 1.50. Oxidized titanium has a refractive index of about 2.7. The colored layer 20 is mixed with a mass ratio of about 1 to 20 mass% of oxidized titanium. Preferably, the colored layer 20 is mixed with 8 mass% of oxidized titanium. Thus, appropriate inorganic colorant other than white, for example, may be used to provide the colored layer 20 colored with a color other than white.

Generally, when assuming that light enters a medium A having a thickness t and an absorptance λ at an intensity I⁰ and the light having passed through the medium A has an intensity I¹, this is represented by a transmission factor T=-log(I¹ / I⁰) =e-λ^{t}. The transmission factor T is represented to include all of the reflection at the incidence plane of the medium A as well as the absorption and diffusion in the medium A. The reflection occurs at an interface of two media having different refractive indexes. When assuming that the medium A has a refractive index n_{A} and the medium B has a refractive index n_{B}, the interface between the medium A and the medium B in the case of the vertical incidence has a reflectivity R={(n_{A}-n₈)/(n_{A}+n_{B})}2. Specifically, a difference in refractive index causes reflection at the interface depending on an incidence angle.

When the colored layer 20, the transparent upper face layer 21 provided at the light-receiving face side, and the sealing member 14, the colored layer 20 has, due to light absorption diffusion caused by coloring agent, the absorptance λ₂₀ that is higher than the absorptance λ₂₁ of the transparent upper face layer 21 and that is higher than the absorptance λ₁₄ of the sealing member 14. Thus, the colored layer 20 has the transmission factor T₂₀ that is lower than the transmission factor T₂₁ of the transparent upper face layer 21 and that is lower than the transmission factor T₁₄ of the sealing member 14. Furthermore, since the colored layer 20 is added with coloring agent, the refractive index n₂₀ of the entire layer is higher than the refractive index n₂₁ of the transparent upper face layer 21 and is higher than the refractive index n₁₄ of the sealing member 14. This causes reflection to occur at the interface between the transparent upper face layer 21 and the colored layer 20.

From a microscopic viewpoint, the colored layer 20 includes therein coloring agent of oxidized titanium having a refractive index higher than the refractive index of EVA of the main material. Thus, reflection occurs at a part including oxidized titanium. Thus, the colored layer 20 functions as a reflective layer that reflects light from the light-receiving face side at the interface with the transparent upper face layer 21 so as to direct the light to the rear side of the solar cell 11. The interior thereof has microscopic reflection at a portion of oxidized titanium.

Thus, the colored layer 20 functions as a reflective layer that is white-colored provided at the rear side of the solar cell 11 and that reflects light having passed from the light-receiving face side through the space sandwiched between the neighboring solar cells 11 so as to direct the light toward the rear side of the solar cell 11. If the colored layer 20 has a thin thickness, the light from the light-receiving face side is easily transmitted to the protective member 17, thus causing a light collection loss. If the colored layer 20 has an increased thickness, the reflection effect is improved. However, when the colored layer 20 and the sealing member 14 sandwich the solar cell 11 and the resultant structure is laminated, the colored layer 20 flows from an end of the protective member 16 in an increased amount, which causes a risk of the contamination of a manufacturing apparatus or the solar cell module 10. Furthermore, the entire sealing member 15 has an increased thickness and an increased shrinkage amount is caused between the solar cells 11 during lamination, thus causing stress to be easily applied to the wiring members 12 and 13. If the colored layer 20 has an increased thickness without changing the thickness of the sealing member 15, then the transparent upper face layer 21 and the intermediate transparent layer 22 must have a reduced thickness. In this case, a disadvantage is caused in that the colored layer 20 is moved to the sealing member 14 at the light-receiving face side and the adhesiveness with the solar cell 11 and the protective member 17. Thus, the thickness of the colored layer 20 is limited by the entire specification of the solar cell module 10. An example of the thickness is about 300 to 400µ.

The intermediate transparent layer 22 is a transparent film provided between the colored layer 20 and the protective member 17. The intermediate transparent layer 22 functions as a buffer layer to provide the mutual adhesion of members of different materials to provide a laminate structure. The intermediate transparent layer 22 can be formed by the same polyethylene-based olefin resin or EVA as in the main material of the colored layer 20. Thus, the intermediate transparent layer 22 has the transmission factor T₂₂ that is the same as the transmission factor T₂₁ of the transparent upper face layer 21 and that is higher than the transmission factor T₂₀ of the colored layer 20. The intermediate transparent layer 22 has the refractive index n₂₂ that is the same as the refractive index n₂₁ of the transparent upper face layer 21 and that is lower than the refractive index n₂₀ of the colored layer 20. An example of the thickness of the intermediate transparent layer 22 is about 100 to 150µm.

Appropriate primer substance is preferably added in order to improve the contact between the intermediate transparent layer 22 and the protective member 17. Primer substance can be low-viscosity liquid including a small amount of non-volatile components (e.g., urethane-based resin, acrylic-based resin).

In this case, the intermediate transparent layer 22 and the protective member 17 may have therebetween another thin transparent layer added with primer substance to provide a multilayer structure of the intermediate transparent layer 22 and a thin transparent layer including primer substance. Alternatively, a transparent resin layer such as polyethylene-based olefin resin or EVA may be provided that is specialized to improve the contact between the intermediate transparent layer 22 and the protective member 17.

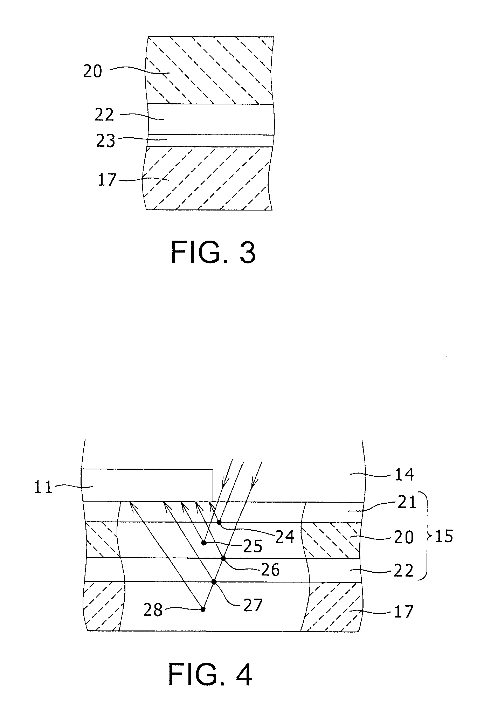

FIG. 3 illustrates an example in which the intermediate transparent layer 22 and the protective member 17 have therebetween a thin protective member-side transparent layer 23 including primer substance.

The protective member-side transparent layer 23 has a transmission factor that is different from the transmission factor of the intermediate transparent layer 22 and that is higher than the transmission factor T₂₀ of the colored layer 20. Even when the refractive index of the protection member-side transparent layer 23 (i.e., the refractive index of the primer substance) is higher than the refractive index of intermediate transparent layer 22, the refractive index of the protection member-side transparent layer 23 is lower than the refractive index n₂₀ of the colored layer 20. The protection member-side transparent layer 23 may have a thickness required to improve the contact and an exemplary thickness may be about 1 to 10µm. Similarly, when the protective member-side transparent layer 23 has thereon a resin transparent layer such as polyethylene-based olefin resin or EVA specialized to improve the contact, the protective member-side transparent layer 23 may have a thickness to improve the contact, such as about 1 to 100µm.

Referring to FIG. 3 again, the protective member 17 is a colored resin film. The protective member 17 can be colored (e.g., for example white-colored) by adding white inorganic colorant (e.g., oxidized titanium, zinc oxide) to transparent main material. The main material can be, for example, olefin resin (e.g., polyethylene terephthalate (PET)). Oxidized titanium may be mixed at a mass ratio of about 1 to 5 mass % or preferably 3 mass %. Alternatively, foam material may be added to resin material to form a resin film whitened by foaming. Resin material to be foamed is preferably PET.

When the protective member 17 is white-colored, the protective member 17 has a low transmission factor and a high refractive index compared with a case where the protective member 17 is composed of main material only. When this is compared with the colored layer 20, the refractive index n₁₇ of the protective member 17 is a high refractive index at the long wavelength side compared with the refractive index n₂₀ of the colored layer 20. Thus, the interface between the intermediate transparent layer 22 and the protective member 17 has a high reflectivity at the long wavelength side compared with the reflection at the interface between the transparent upper face layer 21 and the colored layer 20. From a microscopic viewpoint, the interior of the protective member 17 has a refractive index of a whitened portion higher than the refractive index of the main material as PET, which causes reflection at the whitened portion. Thus, the protective member 17 functions as a reflective layer by which the interface between the protective member 17 and the intermediate transparent layer 22 reflects the light from the light-receiving face side to the rear side of the solar cell 11 and the interior thereof has microscopic reflection occurring at the whitened portion. The microscopic reflectivity is high at the long wavelength side compared with the reflectivity T₂₀ of the colored layer 20.

As described above, with regard to the light from the light-receiving face side, when assuming that the colored layer 20 is the first reflective layer, the protective member 17 functions as the second reflective layer provided further tothe rear side than the first reflective layer. An example of the thickness of the protective member 17 is about 50 to 300µm.

When the solar cell module 10 has a structure not requiring light to be received from the rear side, the protective member 17 can be a not-transparent plate or film. For example, a multilayer film such as a resin film including therein an aluminium foil can be used. In this case, the light from the light-receiving face side can be received by the aluminium foil part and can be directed to the rear side of the solar cell 11. When compared with this, the white-colored protective member 17 functions so that the interface between the white-colored protective member 17 and the intermediate transparent layer 22 in the vicinity of the back face of the sealing member 15 can reflect the light from the light-receiving face side. As described above, the protective member 17 can be white-colored to direct the light to the rear side of the solar cell 11 in a more efficient manner.

The following section will describe the reflection of the light from the light-receiving face side in the above configuration with reference to FIG. 4. FIG. 4 is a partial view of FIG. 2 in which the light path of light from the light-receiving face side is shown by omitting the illustration of parts representing the reflective layer by the diagonal broken lines.

The light from the light-receiving face side having entered the space between the neighboring the solar cells 11 is reflected by the interface 24 between the transparent upper face layer 21 and the colored layer 20 due to a difference between the refractive index n₂₁ of the transparent upper face layer 21 and the refractive index n₂₀ of the colored layer 20. The reflected light is guided to the back face of the solar cell 11.

Light not reflected by the interface 24 between the transparent upper face layer 21 and the colored layer 20 passes through the transparent upper face layer 21 at the transmission factor T₂₁ and enters the colored layer 20. The interior 25 of the colored layer 20 has reflection due to a difference between the refractive index of the main material of the colored layer 20 and the refractive index of the oxidized titanium and the reflected light is guided to the back face of the solar cell 11. The light having passed through the colored layer 20 at the transmission factor T₂₀ is reflected, depending on an incidence angle, by the interface 26 between the colored layer 20 and the intermediate transparent layer 22 due to a difference between the refractive index n₂₀ of the colored layer 20 and the refractive index n₂₂ of the intermediate transparent. The reflected light is guided to the back face of the solar cell 11.

The light having passed through the intermediate transparent layer 22 at the transmission factor T₂₂ is reflected by the interface 27 between the intermediate transparent layer 22 and the protective member 17 due to a difference between the refractive index n₂₂ of the intermediate transparent layer 22 and the refractive index n₂₀, of the colored layer 20, and the reflected light is guided to the back face of the solar cell 11. Light not reflected by the interface 27 between the intermediate transparent layer 22 and the protective member 17 enters the protective member 17. The interior 28 of the protective member 17 has reflection due to a difference between the refractive index of the main material of the protective member 17 and the refractive index of the whitened portion, and the reflected light is guided to the back face of the solar cell 11.

As described above, the intermediate transparent layer 22 is provided further to the rear side than the colored layer 20 functioning as the first reflective layer, and the protective member 17 functioning as the second reflective layer is provided further to the rear side than the intermediate transparent layer 22. This consequently can allow the light from the light-receiving face side to be efficiently guided to and reflected by the back face of the solar cell 11.

### Description of Reference Numerals

10 Solar cell module
11 Solar cell
12 and 13 Wiring member
14 and 15 Sealing member
16 and 17 Protective member
18 and 19 Frame
20 Colored layer
21 Transparent upper face layer
22 Intermediate transparent layer
23 Protective member-side transparent layer
24, 26, and 27 Interface
25 and 28 Interior

## Claims

1. A solar cell module, comprising:
solar cells;
a first reflective layer disposed at the rear sides of the solar cells and including a coloring agent with a higher refractive index than the main material of the first reflective layer;
an intermediate transparent layer disposed at the rear side of the first reflective layer and having a higher transmission factor than the first reflective layer; and
a second reflective layer provided at the rear side of the module, the second reflective layer including a whitened portion having a higher refractive index than the main material of the second reflective layer and having a higher refractive index for the entire layer than the intermediate transparent layer.

2. The solar cell module according to claim 1, wherein: the entire second reflective layer has a refractive index that is higher at a light long wavelength side than the refractive index of the entire first reflective layer.

3. The solar cell module according to claim 1 or 2, wherein: the back face of the solar cell and the first reflective layer have therebetween a transparent upper face layer having a transmission factor higher than that of the first reflective layer and a refractive index lower than that of the first reflective layer.

4. The solar cell module according to claim 1, wherein: the intermediate transparent layer is a compound transparent layer in which a plurality of transparent layers having different refractive indices are layered.
